# EUROPEAN PATENT APPLICATION

(11) **EP 4 531 246 A1**
(43) Date of publication of application: **02.04.2025**
(21) Application number: 23811399.7
(22) Date of filing: 10.03.2023
(51) Int. Cl.: H02K 3/26, H02K 1/14

(54) **AXIAL GAP MOTOR**

(30) Priority: 23.05.2022 WO PCT/JP2022/021163
(71) Applicant: Harmonic Drive Systems Inc., Shinagawa-ku Tokyo 140-0013 (JP)
(72) Inventor: TAKEDA, Toru, Azumino-shi, Nagano 399-8305 (JP); YAMAGUCHI, Ryutaro, Azumino-shi, Nagano 399-8305 (JP)
(74) Representative: TBK
(86) International application number: PCT/JP2023/009370
(87) International publication number: WO 2023/228518

(57) **Abstract**

A motor stator (5) of an axial gap motor (1) is configured such that a printed circuit board (20) that has motor coils (30) of various phases disposed thereupon is stacked on a stator core (10) in the axial direction. The printed circuit board (20) is a stacked body in which phase boards (21; 21U, 21V, 21W) of various phases are stacked in the axial direction with spacers (26) interposed therebetween. Each phase board is a stacked body of two insulating boards (22(1), 22(2)), an on the respective surfaces of these insulating boards, a distributed-winding motor coil (30) is formed, the motor coil comprising a coil winding pattern being formed by a copper foil or the like. By comprising distributed-winding coils with a high stacking factor, it is possible to realize a flat axial gap motor having improved insulation and breakdown voltage characteristics.

## Description

### TECHNICAL FIELD

The present invention relates to an axial gap motor, and particularly relates to an axial gap motor provided with distributedly wound motor coils.

### BACKGROUND ART

Distributedly wound axial gap motors have been proposed in Patent documents 1 and 2. For example, in the axial gap motor disclosed in Patent document 1 (FIG. 27 and 28), motor coils of three phases are each distributedly wound over a plurality of salient-pole teeth, thereby reducing spatial harmonics of magnetic flux and lowering vibration and noise. Patent document 3 proposes an axial gap motor provided with concentratedly wound motor coils, a fixed element of the axial gap motor being provided with a magnetic body and a plurality of wiring boards that are laminated on the magnetic body from an axial direction, and respective coil winding patterns being formed on the wiring boards.

### PRIOR-ART DOCUMENT

### PATENT DOCUMENT

Patent Document 1: JP-A 2008-193838
Patent Document 2: JP-A 2006-187091
Patent Document 3: JP-A 2018-93650

### DISCLOSURE OF THE INVENTION

### PROBLEMS TO BE SOLVED BY THE INVENTION

Distributedly wound motors are superior to concentratedly wound motors in that rotating magnetic fields produced by motor stators in the former are closer to sine waves and in that the former have exceptional motor rotation characteristics and output performance. However, it is more difficult to increase a space factor in distributed windings than in concentrated windings. Specifically, there does not exist any winding mechanism (slotter) or main winding technology dedicated to distributed windings for axial gap motors. Therefore, existing distributed windings are wound through a manual operation, which results in low precision (space factor).

Additionally, when coil windings are disposed spanning a plurality of cores (salient-pole teeth) that are formed on a motor stator, coil windings of each phase are disposed in a state of being stacked in an axial direction (direction of a motor center axis). As a result, the axial length of the motor stator in distributedly wound motors is greater than that in concentratedly wound motors, the increased axial length being a drawback for achieving a flatter profile, which is an advantage of axial gap motors. It is thought that laminating wiring boards in the axial direction, the wiring boards having formed thereon coil winding patterns made of copper foils, as disclosed in, e.g., Patent Document 3, would suppress any increase in axial length. However, in cases where boards are directly laminated in a state in which the copper-foil coil winding patterns are exposed at surfaces of the boards, the spatial distance therebetween cannot be ensured, the dielectric withstand voltage characteristics required for the motor deteriorate, and a risk of short-circuiting arises.

In view of the foregoing, it is an object of the present invention to provide a flat axial gap motor provided with distributedly wound motor coils having a high space factor, the axial gap motor exhibiting improved dielectric strength.

### MEANS USED TO SOLVE THE ABOVE-MENTIONED PROBLEMS

According to the present invention, there is provided an axial gap motor comprising a motor rotor and a motor stator that face one another across a fixed gap in an axial direction, the axial gap motor being characterized in that:
the motor rotor is provided with a rotor disk, and a rotor magnet that is disposed on the rotor disk;
the motor stator is provided with a stator core, a printed wiring board that is laminated on the stator core in the axial direction, and a plurality of motor coils that respectively correspond to a plurality of phases formed on the printing wiring board;
the stator core has a stator-core end surface on which the printed board is laminated, and salient-pole teeth that protrude in the axial direction from the stator-core end surface are arranged on the stator-core end surface at fixed angular intervals in a circumferential direction centered on a motor center axis;
the printed wiring board is a laminated board provided with a plurality of phase boards that are laminated with a fixed inter-board gap therebetween in the axial direction, and a gap-forming member that is positioned between the phase boards, which are adjacent to one another in the axial direction, in order to ensure the inter-board gap;
each of the phase boards is provided with an insulated board, a plurality of salient-pole-tooth passage holes through which the salient-pole teeth are respectively inserted and which are formed in the insulated board, and the motor coils that belong to one phase allocated to the phase board; and
the motor coils of each phase have a distributedly wound coil winding pattern formed on the insulated board.

In the present invention, the distributedly wound coil winding patterns are formed on the surface of the printed wiring board (PCB board) using copper foils or other electroconductive metal foils, therefore making it possible to increase the space factor in the distributed windings. The winding structure spanning the plurality of salient-pole teeth is similar to that of prior-art distributed windings, but because a printed wiring board (PCB board) is used, any increase in dimensions caused by stacking of coil winding patterns in a length direction (axial direction) can be suppressed, which is advantageous for achieving a flatter motor profile.

In the printed wiring board, the gap-forming member is disposed between adjacent phase boards, and the phase boards of each phase are laminated in a state in which the fixed inter-board gap is formed therebetween due to the gap-forming member. Unlike instances in which a phase board is directly laminated in the axial direction onto the surface of a separate phase board in which a coil winding pattern of a metal foil is formed on the surface thereof, it is possible to ensure a sufficient spatial distance between the phase boards of each phase. The dielectric strength required for a motor can be maintained, and the danger of short-circuiting of the windings also decreases.

An insulating resin material (mold, varnish, or the like) can easily be filled into the inter-board gap in accordance with the spatial shape of the gap. This makes it possible to simultaneously improve dielectric strength, improve heat dissipation properties (for generation of heat by the coil winding patterns), and achieve fixation between the phase boards.

The printed wiring board is a laminated board in which a plurality of phase boards, e.g., three phase boards respectively having a U phase, a V phase, and a W phase, are laminated in the axial direction. In work for assembling the printed wiring board, the phase boards may merely be laminated in a state of being positioned in the circumferential direction. As a result, the number of work steps for distributed windings that require excessive labor to complete can be reduced, and the number of assembly steps and the number of components can also be reduced, therefore improving productivity.

### BRIEF DESCRIPTION OF THE DRAWINGS

FIG. 1A is a schematic diagram showing an axial gap motor to which the present invention is applied;
FIG. 1B is a perspective view showing a motor stator and a motor rotor;
FIG. 1C is a side view showing the motor stator;
FIG. 1D is a plan view of phase boards constituting a printed wiring board of the motor stator;
FIG. 1E is a perspective view showing spacers and three phase boards constituting the printed wiring board of the motor stator, specifically showing a state in which the phase boards are separated from one another;
FIG. 2 is a perspective view showing a stator core of the motor stator;
FIG. 3(A) is a perspective view showing a phase board that is made from a first board and a second board, and FIG. 3(B) is a perspective view showing a state in which the first and second boards are separated from one another;
FIG. 4 is a perspective view showing the stator core and the printed wiring board constituting the motor stator, specifically showing a state in which the three phase boards constituting the printed wiring board are separated from one another, and not showing the spacers;
FIG. 5 is an explanatory diagram showing an example of neutral-point connection patterns formed on the three phase boards;
FIG. 6 is a wiring diagram showing one example of a connection circuit of motor coils in the case of a three-phase motor; and
FIG. 7 is a schematic diagram showing another example of an axial gap motor.

### MODE FOR CARRYING OUT THE INVENTION

A distributedly wound axial gap motor according to embodiments of the present invention is described below with reference to the accompanying diagrams. The embodiments described below illustrate examples of the present invention, but the present invention is in no way limited thereto. For example, the number of phases, the number of magnet poles, the number of slots, the shape of magnets, and the shape of slots are not limited to the numbers and shapes in the embodiments below. The distributed windings may be wound using any of coaxial winding, lap winding, or wave winding.

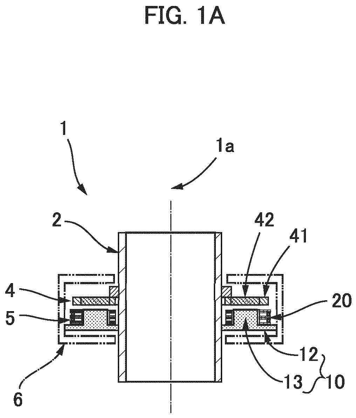

FIG. 1A is a schematic diagram showing a distributedly wound axial gap motor. In the present example, the axial gap motor 1 (referred to below simply as the "motor 1") is a three-phase motor having eight poles and 36 slots. As shown in FIG. 1A, the motor 1 has: a hollow motor shaft 2; a motor rotor 4 that is coaxially secured to the hollow motor shaft 2; a motor stator 5 that coaxially faces the motor rotor 4 at a fixed gap in an axial direction, which is the direction following a central axis 1a; and a motor housing 6 to which the motor stator 5 is secured.

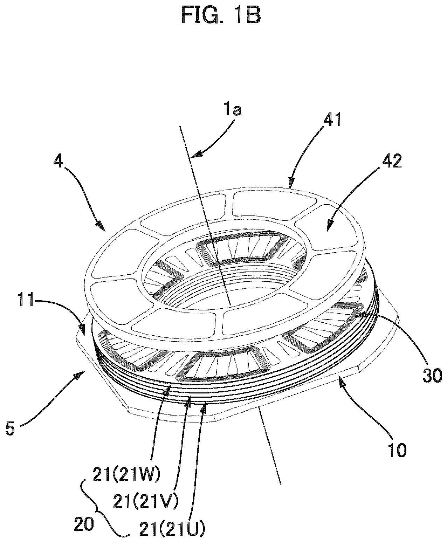

FIG. 1B is a perspective view showing the motor rotor 4 and the motor stator 5. The motor rotor 4 and the motor stator 5 are shown in a state in which a gap therebetween is enlarged. As shown, the motor rotor 4 is provided with an annular rotor disk 41 that is made from iron or another ferromagnetic material, and a magnet 42 that is attached to the rotor disk 41. In the present example, eight magnets 42 are embedded in the rotor disk 41 at fixed angular intervals in a circumferential direction.

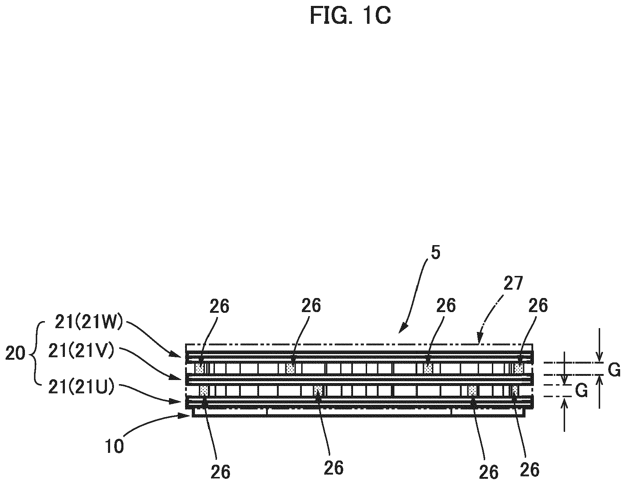

FIG. 1C is a side view showing the motor stator 5. With reference to FIGS. 1B and 1C, the motor stator 5 is provided with a plate-form stator core 10 that is made from a ferromagnetic material, and an annular printed wiring board 20 (PCB board) that is coaxially laminated on an end surface 11 of the stator core 10, the end surface 11 being located on the motor-rotor 4 side. The printed wiring board 20 is configured such that motor coils 30 that respectively correspond to a U phase, a V phase, and a W phase, other circuits, and the like are printed onto the printed wiring board 20.

As shown in FIG. 1C, the printed wiring board 20 is a laminated board configured such that a plurality of phase boards 21 having the same configuration sandwich spacers 26 for forming an inter-board gap and are laminated coaxially in the axial direction. In the present example, the printed wiring board 20 is a laminated board configured such that three phase boards 21 are laminated coaxially in the axial direction with fixed inter-board gaps G interposed therebetween, the inter-board gaps G being formed by the spacers 26. A portion of the printed wiring board 20 of the motor stator 5 configured in this manner is covered by a mold material 27 made from an insulating resin, as shown by the virtual-line frame in FIG. 1C.

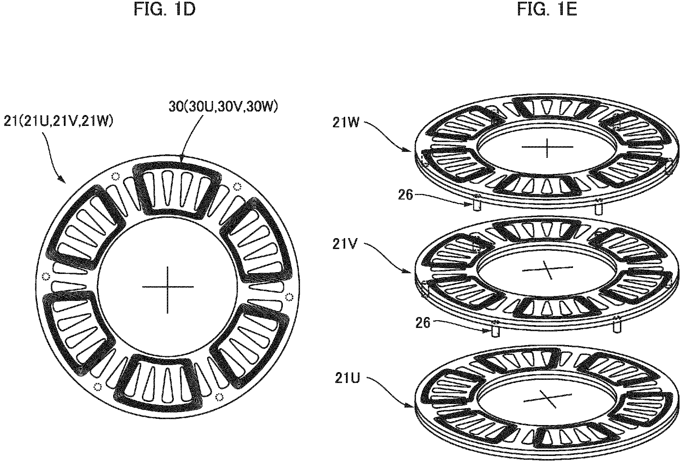

FIG. 1D is a plan view of the phase boards 21 constituting the printed wiring board 20 of the motor stator 5. FIG. 1E is a perspective view showing the spacers 26 and three phase boards 21 constituting the printed wiring board 20, specifically showing a state in which the phase boards 21 are separated from one another. As shown in FIGS. 1D and 1E, the three phase boards 21 respectively are a U-phase board 21U on which a U-phase motor coil 30U is formed, a V-phase board 21V on which a V-phase motor coil 30V is formed, and a W-phase board 21W on which a W-phase motor coil 30W is formed. In the present example, e.g., six spacers 26 that are disposed at equiangular intervals in the circumferential direction are sandwiched between the U-phase board 21U laminated on the stator core 10 and the V-phase board 21V laminated on the U-phase board 21U. Similarly, e.g., six spacers 26 are sandwiched between the V-phase board 21V and the W-phase board 21W laminated on the V-phase board 21V. The spacers 26, which are members for forming the inter-board gap, are fabricated as separate members from the phase boards and are disposed between the phase boards. Alternatively, the spacers 26 are formed integrally with parts of the phase boards 21 as protruding parts for forming the inter-board gap.

The configuration of each part of the motor 1 shall now be described in further detail.

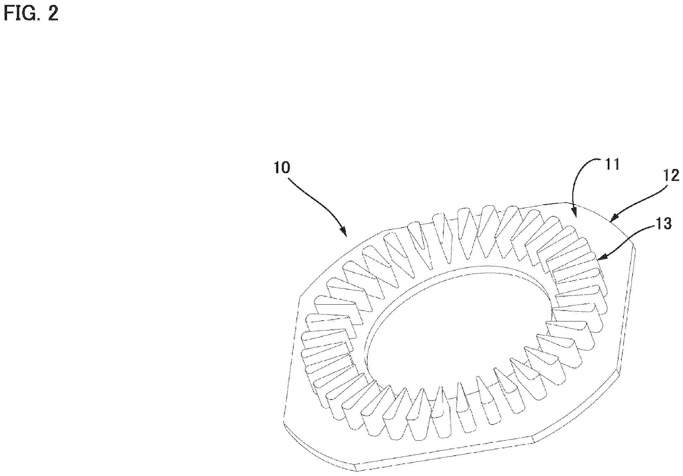

FIG. 2 is a perspective view showing the stator core 10 of the motor stator 5. The stator core 10 is made from, e.g., a sintered body or a green compact, the stator core 10 being provided with: a plate-form back yoke 12 in which a circular opening is formed in the center thereof; and salient-pole teeth 13 that are formed on an end surface 11 of the back yoke 12, the end surface 11 being the motor-rotor-side end surface. The salient-pole teeth 13 protrude in the axial direction and are arranged at fixed angular intervals in the circumferential direction about the center axis 1a. In the present example, the salient-pole teeth 13 are formed corresponding to the 36 slots, 36 being an integral multiple of 3 (the number of phases).

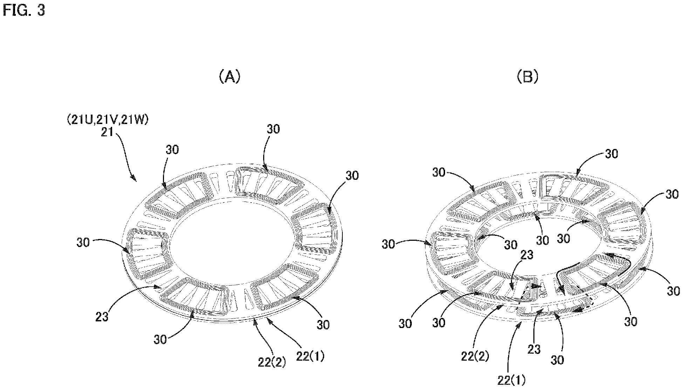

FIG. 3(A) is a perspective view showing one of the phase boards 21 (21U, 21V, 21W) constituting the printed wiring board 20, and FIG. 3(B) is a perspective view showing a state in which two insulated boards constituting the phase board 21 are separated from one another. As shown in FIGS. 3(A) and 3(B), the phase board 21 is a two-layer board in which two insulated boards 22(1), 22(2) having the same shape are laminated in the axial direction. The insulated boards 22(1), 22(2) are each formed in a disk shape in which a circular opening is formed in the center thereof. Salient-pole-tooth passage holes 23 passing through in a thickness direction (axial direction) are formed in the insulated boards 22(1), 22(2). 36 salient-pole-tooth passage holes 23 are formed at fixed angular intervals in the circumferential direction. A plurality of motor coils 30 are disposed at fixed angular intervals on the surfaces (surfaces located on the motor-rotor side) of the insulated boards 22(1), 22(2). The motor coils 30 are distributedly wound and are defined by coil winding patterns made from copper foils. In the present example, the coil winding patterns, which are each printed so as to surround four adjacent slots, are formed at six locations at equiangular intervals in the circumferential direction.

The two insulated boards 22(1), 22(2) configured in this manner are laminated in the axial direction and integrated in a state of being shifted relative to one another by an angle corresponding to three slots in the circumferential direction, whereby one phase board 21 is configured. In this instance, as shown in FIG. 3(B), the orientation of a current of the motor coil 30 on the upper-side insulated board 22(2) is set as a CCW direction as shown by the solid-line arrows, and the orientation of a current of the motor coil 30 on the lower-side insulated board 22(1) is set as a CW direction that is opposite from the CCW direction as shown by the dashed-line arrows. A through-hole (not shown) is formed in the insulated board 22(2), the coil winding patterns formed on the two insulated boards being connected via the through-hole.

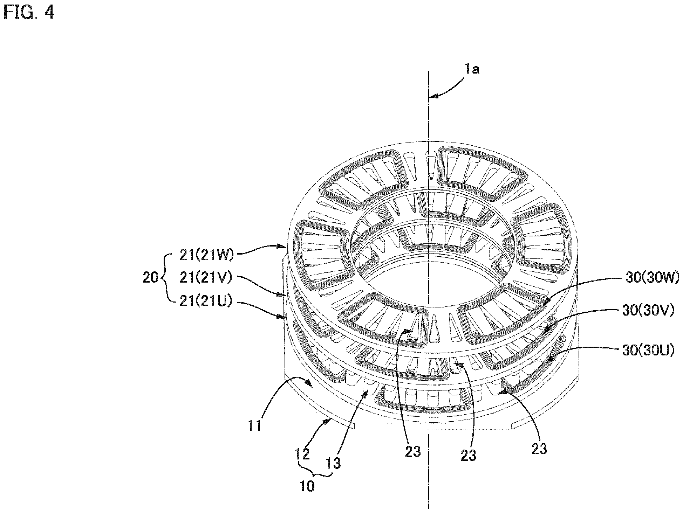

FIG. 4 is a perspective view showing the lamination state of the three phase boards 21, specifically showing a state in which the three phase boards 21 are separated from one another, and not showing the spacers 26 between the phase boards 21. The three phase boards 21 having the same configuration are laminated coaxially in the axial direction and are integrated with the end surface 11 of the back yoke 12 in the stator core 10, as a result of which the printed wiring board 20 is configured. The three phase boards 21 are laminated in a state of being shifted relative to one another by an angle corresponding to one slot in the circumferential direction. In the present example, because there are 36 slots, the phase boards 21 are shifted in the circumferential direction by 10° (i.e., 360°/36 slots) in terms of mechanical angle.

As indicated previously, the phase board 21 that is laminated on the end surface 11 of the back yoke 12 is the U-phase board 21U, and the motor coil 30 of the U-phase board 21U is the U-phase motor coil 30U. The phase board 21 that is laminated on the U-phase board 21U is the V-phase board 21V on which the V-phase motor coil 30V is printed, and the phase board 21 that is laminated on the V-phase board 21V is the W-phase board 21W on which the W-phase motor coil 30W is printed. The coil winding patterns of the motor coils 30U, 30V, 30W are respectively formed on the phase boards 21U, 21V, 21W, and neutral-point connection patterns for connecting the coil winding patterns of each of the U, V, and W phases at a neutral point are also formed, although FIG. 4 does not show this configuration.

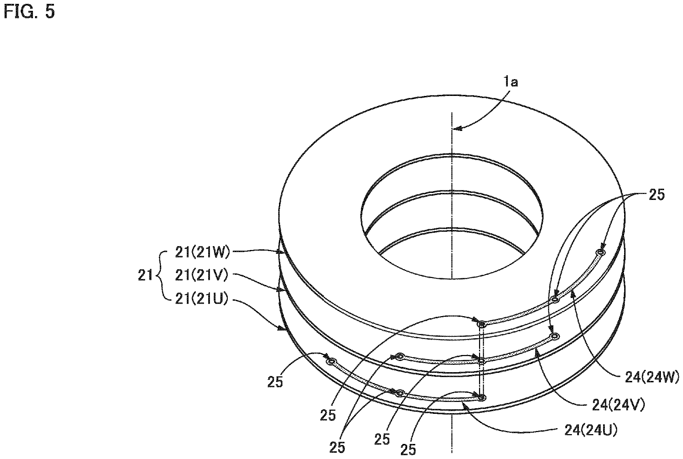

FIG. 5 is an explanatory diagram showing neutral-point connection patterns formed on the phase boards 21 (21U, 21V, 21W). The neutral-point connection patterns 24 (24U, 24V, 24W) are formed using copper foils on the surfaces (surfaces located on the motor-rotor 4 side) of the phase boards 21 (21U, 21V, 21W), together with the coil winding patterns (not shown). The neutral-point connection patterns 24 have a prescribed length and extend in the circumferential direction. In the present example, the neutral-point connection patterns 24 have an arcuate shape and spread over a fixed angle centered on the central axis 1a. A plurality of through-holes 25 passing through in the thickness direction are also formed in the phase boards 21. The through-holes 25 are formed along the neutral-point connection patterns 24 at angular intervals that correspond to the amount of circumferential-direction shifting of the phase boards 21.

In a state in which the three phase boards 21 having the same configuration are laminated in the axial direction to configure the printed wiring board 20, one of the through-holes 25 in each of the neutral-point connection patterns 24U, 24V, 24W of the phase boards 21U, 21V, 21W is aligned. After the phase boards 21U, 21V, 21W are laminated, the coil winding patterns of each phase are soldered via the three through-holes 25 located at the aligned positions and are connected through welding or the like. This yields a state in which the motor coils 30 of each phase are star-connected using the through-holes 25 as a neutral point.

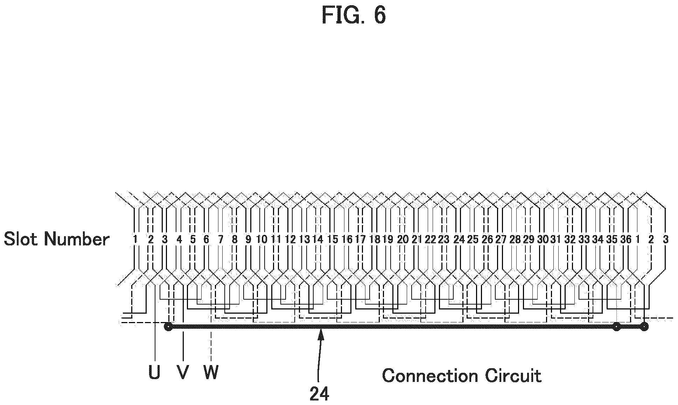

FIG. 6 shows one example of a connection circuit of the motor coils 30 of the three phases (U, V, W). Wiring patterns for forming crossover lines or another circuit connection linking the coil winding patterns that regulate the motor coils 30 of each phase are also patterned onto the phase boards 21 using copper foils or the like. As indicated previously, the coil winding patterns of each phase are connected to each other at a neutral point (position of the mutually aligned through-holes) via the neutral-point connection patterns 24 of each phase.

As described above, the printed wiring board 20, which is a laminate of the phase boards 21U, 21V, 21W of U, V, and W phases on which are printed the motor coils 30U, 30V, 30W of each phase regulated by the copper-foil coil winding patterns, is used in the motor 1 according to the present example. The phase boards 21 (21U, 21V, 21W) having the same structure are laminated on the back yoke 12 in a number corresponding to the number of phases, whereby the motor stator 5 is configured. The phase boards 21 (21U, 21V, 21W) of each phase are formed as two-layer integrated structures in each of which two insulated boards 22(1), 22(2) are laminated. Between the insulated boards 22(1), 22(2), the motor coils 30 (coil winding patterns) are shifted in the circumferential direction, and the orientation of currents is inverted, whereby distributed winding is achieved.

Thus, the distributedly wound coil winding patterns are formed on the surface of the printed wiring board 20 using copper foils or the like. Accordingly, a space factor in distributed windings can be increased, a degree of freedom in designing windings can be improved, and any of coaxial winding, lap winding, or wave winding can be employed in the distributed windings. The incidence of damage and burnout in the coils can also be suppressed.

The winding structure spanning the plurality of salient-pole teeth 13 is similar to that in the case of prior-art distributed windings, but the printed wiring board 20 is used. Thus, any increase in dimensions caused by stacking of coil winding patterns in a length direction (axial direction) can be suppressed, which is advantageous for flattening the motor.

Since no adverse effects such as enlargement of coil ends of the distributedly wound motor coils will arise, it is not necessary to ensure any space in which to dispose the motor coils on the inner-peripheral and outer-peripheral sides of the motor stator. Thus, it is possible to realize, e.g., a motor having a large hollow diameter.

The copper-foil patterns on the printed wiring board have higher precision than manually applied windings. Thus, variation in induced voltage values, waveform maximum values (P-P), and execution values (rms) is low. As a result, it is possible to contribute to stabilization (reduction in variation) of motor characteristics.

The number of components can be greatly reduced, and the number of assembly steps can also be lowered. Specifically, the printed wiring board is a laminated board in which a plurality of phase boards, e.g., three phase boards respectively having a U phase, a V phase, and a W phase, are laminated in the axial direction. In work for assembling the printed wiring board, the phase boards may merely be laminated in a state of being positioned in the circumferential direction. The phase boards can also be configured to have the same structure. As a result, work steps for distributed windings that require excessive labor to complete can be reduced, and the number of assembly steps and the number of components can also be reduced, therefore improving productivity.

Neutral-point connection patterns are also formed on the phase boards 21, together with the coil winding patterns of the motor coils of each phase. With the phase boards 21 in a laminated state, one through-hole in each phase is positioned in alignment with each other. The coil winding patterns of each phase are connected via the through-holes using the position of the aligned through-holes as a neutral point.

When linking neutral points in prior-art three-phase motors, terminals of coil windings are linked together as described below. Specifically, it is common for the positions of the terminals of the coil windings of each phase to not be aligned, irrespective of whether the coil windings are distributedly wound or concentratedly wound. Therefore, in cases where the coil windings of each phase are linked together at a neutral point, it has been necessary to partially change the length of the coil windings for design or manufacturing considerations, or to link together the terminals via interpolation with a separate connection component.
(a) The length of the coil windings is adjusted for each phase, and the terminals are linked together at one location (through soldering, welding, or the like).
(b) The terminals are linked together using a busbar or other separate connection component.

In the case of (a), problems are presented in that manufacturing conditions become complicated, difficulty is presented in positioning the neutral points, and variation in the positions of the neutral points occurs. In the case of (b), problems are presented in that the number of components increases, connections are made at a plurality of locations, and increases in cost and the like are brought about.

In the present example, neutral-point connection patterns having a prescribed length are formed on the phase boards along the circumferential direction in consideration of the lamination state of the phase boards, and through-holes are formed at a plurality of locations along the neutral-point connection patterns, as described above. This makes it possible to easily and precisely carry out work for connecting the coil winding patterns of each phase at the neutral point while maintaining standardization of the phase boards.

In the motor 1 according to the present example, the spacers 26 are sandwiched between the phase boards 21U, 21V, 21W of each phase, and the phase boards are laminated. In cases where copper-foil patterns exposed at the surfaces of boards are directly stacked, there is no spatial distance therebetween, dielectric withstand voltage characteristics required for the motor deteriorate, and a risk of short-circuiting arises. However, in the present example, the spacers 26 are sandwiched between the phase board 21U and the phase board 21V, whereby the fixed inter-board gap G therebetween is ensured, and, similarly, the spacers 26 are also sandwiched between the phase board 21V and the phase board 21W, whereby the fixed inter-board gap G therebetween is ensured.

Due to the configuration described above, gaps (spaces) are provided between the phase boards, thereby making it possible to improve dielectric resistance. Providing gaps (spaces) between the phase boards also makes it possible to easily fill an insulating resin material (molding materials, varnishes, or the like) into the gaps between the phase boards in accordance with the shapes of the gaps. As a result, it is possible to simultaneously improve dielectric strength, improve heat dissipation properties (for generation of heat by the coil winding patterns), and mutually secure the phase boards.

### (Other embodiments)

An example was provided above in which the motor 1 is a three-phase motor having 8 poles and 36 slots; however, as indicated previously, the number of magnet poles, the number of slots, and other features are not limited to those in the example described above. The shapes of the magnets and the slots also are not limited to those in the example described above, and various shapes and structures can be employed.

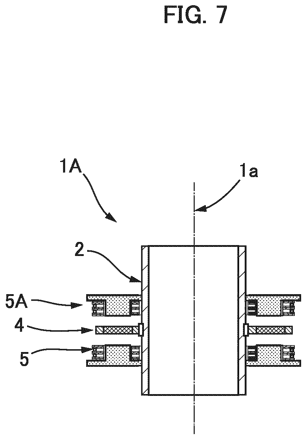

In cases where an increase in torque is required, the motor stator having the configuration described above may be configured to have multiple stages in the axial direction. For example, in the distributedly wound axial gap motor 1A shown in FIG. 7, a motor stator 5 and a motor stator 5A having the same configuration are disposed symmetrically on both sides of a motor rotor 4 so as to sandwich the motor rotor 4. Similarly, the motor rotor and the set of motor stators can be configured to have a greater number of stages.

## Claims

1. An axial gap motor comprising a motor rotor and a motor stator that face one another across a fixed gap in an axial direction,
the motor rotor being provided with a rotor disk, and a rotor magnet that is disposed on the rotor disk,
the motor stator being provided with a stator core, a printed wiring board that is laminated on the stator core from the axial direction, and a plurality of motor coils that respectively correspond to a plurality of phases formed on the printing wiring board,
the stator core being provided with a stator-core end surface on which the printed wiring board is laminated, and salient-pole teeth that protrude in the axial direction from the stator-core end surface being arranged on the stator-core end surface at fixed angular intervals in a circumferential direction centered on a motor center axis,
the printed wiring board being a laminated board provided with a plurality of phase boards that are laminated with a fixed inter-board gap therebetween in the axial direction, and a gap-forming member that is positioned between the phase boards, which are adjacent to one another in the axial direction, in order to ensure the inter-board gap,
each of the phase boards being provided with an insulated board, a plurality of salient-pole-tooth passage holes through which the salient-pole teeth are respectively inserted and which are formed in the insulated board, and the motor coils that belong to one phase allocated to the phase board, and
the motor coils of each phase having a distributedly wound coil winding pattern formed on the insulated board.

2. The axial gap motor according to claim 1, wherein
the gap-forming member is a board protruding part that protrudes in the axial direction and is formed integrally with the insulated board on one or both of the phase boards that are adjacent in the axial direction.

3. The axial gap motor according to claim 1, wherein:
the insulated boards of each of the phase boards are each provided with a first board and a second board that are laminated in the axial direction;
the motor coils of each phase are each provided with a distributedly wound first coil winding pattern that is formed on a surface of the first board on the side opposite from the second board, and a distributedly wound second coil winding pattern that is formed on a surface of the second board on the side opposite from the first board; and
the first coil winding pattern and the second coil winding pattern are formed at positions that are shifted relative to one another by a fixed angle in the circumferential direction.

4. The axial gap motor according to claim 3, wherein:
the plurality of phases include three phases of a U phase, a V phase, and a W phase; and
three of the phase boards are laminated in a state of being shifted relative to one another by a fixed angle in the circumferential direction so as to function as a U-phase board, a V-phase board, and a W-phase board, respectively.

5. The axial gap motor according to claim 4, wherein:
each of the U-phase board, the V-phase board, and the W-phase board is provided with
a neutral-point connection pattern that is made from an electroconductive metal foil and extends in the circumferential direction, and
through-holes that are formed at a plurality of positions along the neutral-point connection pattern; and
with the U-phase board, the V-phase board, and the W-phase board in a laminated state, one of the through-holes in the U-phase board, one of the through-holes in the V-phase board, and one of the through-holes in the W-phase board are aligned with one another, and a neutral point is defined.

6. The axial gap motor according to claim 1, wherein:
a first motor stator and a second motor stator are provided as the motor stator; and
the first and second motor stators face the motor rotor from both sides in the axial direction.
